# EUROPEAN PATENT APPLICATION

(11) **EP 2 717 086 A1**
(43) Date of publication of application: **09.04.2014**
(21) Application number: 11866373.1
(22) Date of filing: 14.11.2011
(51) Int. Cl.: G02F 1/13

(54) **OPENING AND CLOSING DEVICE OF AUTOCLAVE, AND AUTOCLAVE**

(30) Priority: 25.05.2011 KR 20110049528; 16.09.2011 KR 20110093503
(71) Applicant: Samin Eng., Co, Gwangju-si 506-258 (KR)
(72) Inventor: CHOI, Gilwoong, Gwangju-si 500-902 (KR)
(74) Representative: Mittler, Enrico
(86) International application number: PCT/KR2011/008678
(87) International publication number: WO 2012/161391

(57) **Abstract**

The present invention relates to an opening and closing device of an autoclave and the autoclave, wherein: supplying and discharging of a product to a chamber having a sealed structure can be performed automatically, and the occurrence of accidents caused by back pressure is structurally prevented; and a product bonded by pre-load is heated and transferred whereby energy loss is minimized and the product is cooled off uniformly, thereby improving the quality of the product. According to the present invention, an opening and closing device of an autoclave comprises: a front opening and closing unit (20) which is mounted on an outer side of a front part of a square container-shaped chamber (10) having a chamber inlet port (14) through which a product is inserted; a rear opening and closing unit (40) which is mounted on an outer side of a chamber outlet port (15) formed on the rear side part of said chamber (10) such that said product is discharged; and an opening and closing means which respectively opens and closes, by internal pressure of said chamber (10), a product inlet port (22) and a product outlet port (42) that are respectively formed in said front opening and closing unit (20) and said rear opening and closing unit (40).

## Description

### Cross-Reference To Related Application

This application claims the benefit of Korean Patent Application No.10-2011-0049528, filed on May 25, 2011 and Korean Patent Application No.10-2011-0093503, filed on September 16, 2011 in the Korean Intellectual Property Office, the disclosure of which is incorporated herein by reference.

### Technical Field

The present invention relates to an opening and closing device of an autoclave and the autoclave that can automatically supply and discharge a product to a chamber having a sealed structure and that can structurally prevent a safety accident from occurring according to a back pressure and that can minimizing energy loss by transferring while heating a product bonded by a pre-load and that can improve a quality of the product by uniformly cooling the product.

### Background Art

In general, a high pressure reaction chamber is a device that injects air to the inside of a device and that raises a temperature thereof to a temperature of injected air through a heating device and that constantly presses products housed at the inside of the device, and is referred to as an autoclave, and is used for processing of a flat plate display or bonding safety glass.

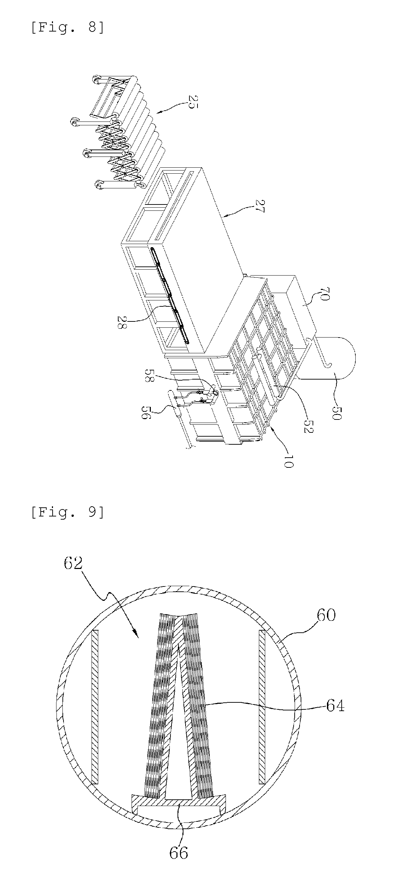

As shown in FIG. 9, in order to process a large amount of products at once, after disposing products 64 in a tray 66 in an overlapped state, the products 64 are disposed at the inside 62 of an internal pressure vessel, and by closing a lid thereof, the internal pressure vessel is heated in a sealed state, maintains a constant temperature, and performs a pressing operation.

Therefore, in a state in which products are stacked at one time, because heating is performed, until an entire portion of products arrives at a desired heating temperature, much time is consumed, and even when a pressing operation is performed, until an uniform pressure is transferred over an entire portion of a stacked product, there is a problem that much time is consumed. Further, after the heating and pressing processing work is performed, in order to withdraw the product to the outside, an internal pressure and an internal temperature of an autoclave should be lowered and much standby time is thus consumed and thus there is a problem that productivity is greatly lowered.

Further, nowadays, because a flat plate display is gradually formed in a large size and bonding safety glass is a product of a very large size, such a convention autoclave should be formed in a large size to correspond to a size of a product to process, and in order to manufacture an autoclave formed in a large size, a much production cost is consumed and an operation and maintenance cost increases. Further, due to operation that takes out a product formed in a large size, a process time is delayed, and in an in-line equipment for mass production, there is a problem that an inaccurate defect and a general tact time increases.

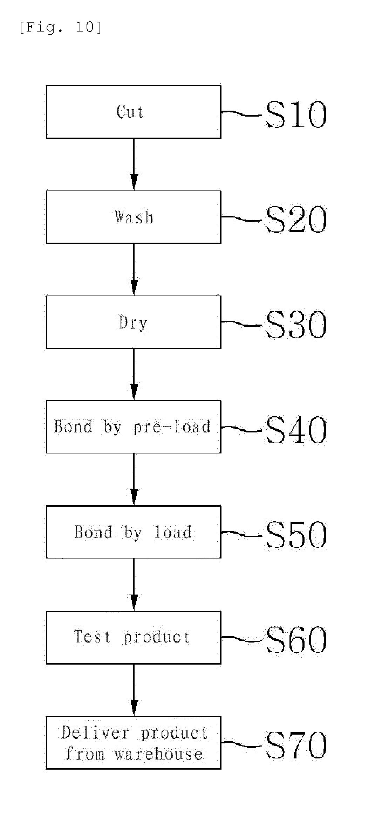

In a conventional method of manufacturing bonding safety glass, wide flat plate glass is cut (S10), washed (S20), and dried (S30) in a predetermined size, as shown in FIG. 10.

Thereafter, by interposing a polyvinyl butyral film between two flat plate glass and by heating the film in an oven installed in a next stage through a conveyor at a temperature of about 70° to 80°C for about 2 to 3 minutes, flat plate glass is bonded by a pre-load (S40). The flat plate glass bonded by a pre-load again executes bonding by a load that heats for about 3 hours in an autoclave at about 120° to 140°C (S50), a product is taken out from the autoclave and is cooled, and the processed product is tested (S60), and the product is produced via step (S70) of delivering the tested product from a warehouse.

However, a conventional autoclave is used in a sealed chamber form, and in a process of maintaining such a sealed chamber in a high temperature and a high pressure, because a probability that a crack may occur at a wall surface of the chamber is high, there was a problem that the chamber may explode and while heating and pressing air injected to the inside, air may be lost through an opening and closing means of the autoclave.

Therefore, in order to close contact an outer edge of an opening and closing means that can open and close the autoclave device and the outside of an autoclave device, sealing is performed by forming a part and a bladder between the outside of the autoclave device and the opening and closing means, and the outer edge of the opening and closing means and the outside of the autoclave device close contact using a separate compression means formed with a piston driven by a cylinder and a support member attached to one end of the piston and thus various methods that enable air not to be lost was suggested. However, because such a compression means is formed with many devices, there is a problem that a structure of an autoclave device becomes complicate, and the compression means cannot be accurately sealed and thus there is a problem that reliability of a product cannot be secured. Further, in process of discharging a pressure of the autoclave device in a state of a high temperature and a high pressure, a possibility that a safety accident may occur is high. In other words, in a state in which a pressure is not completely discharged, as a worker opens an autoclave, there is a structural problem in which a safety accident may occur.

### Technical Problem

The present invention has been made in view of the above problems, and provides an opening and closing device of an autoclave that can reduce a tact time by automating the supply and the discharge to a chamber for processing of a product and that can structurally prevent a safety accident from occurring according to a back pressure. Further, by simply forming such a device, productivity of a product can be greatly improved.

The present invention provides an autoclave that can minimize energy loss by heating a glass plate bonded by a pre-load with heating air and that can produce a single product while greatly improving a quality of a product by cooling the plate by uniformly injecting cooling air over an entire product.

The present invention provides an opening and closing device of an autoclave and the autoclave that can easily house a product, even if a product is formed in a large size and in which more effective quality management is available in an appropriate form in in-line of a production line for mass production, as a smooth operation is available without decline of productivity.

### Technical Solution

In accordance with an aspect of the present invention, there is an opening and closing device of an autoclave including: a front opening and closing portion 20 mounted at the outside of a front surface portion of a quadrangle-shaped chamber 10 in which a chamber injection port 14 is formed to receive injection of a product; a rear opening and closing portion 40 mounted at the outside of a chamber discharge port 15 formed in a rear surface portion of the chamber 10 so as to discharge the product; and an opening and closing means for opening and closing a product injection port 22 and a product discharge port 42 formed in the front opening and closing portion 20 and the rear opening and closing portion 40, respectively by an internal pressure of the chamber 10.

Preferably, the opening and closing means is a cylinder-shaped opening and closing rod 34, and the front opening and closing portion 20 and the rear opening and closing portion 40 include: a front housing 21 and a rear housing 41 in which opening and closing rod moving portions 36 and 46, respectively, are formed to vertically move the opening and closing rod 34; and an opening and closing driving cylinder 30 mounted at a bottom surface and for vertically moving the opening and closing rod 34.

Preferably, in the product injection port 22 and the product discharge port 42, at an inner side surface thereof adjacent to the opening and closing rod moving portions 36 and 46, an opening and closing rod receiving portion 24 engraved in a half-circular arc shape so as to receive to close contact the opening and closing rod 34 is formed.

Preferably, the opening and closing driving cylinder 30 includes a cylinder rod 31 and an opening and closing guide 32 mounted in an end portion of the cylinder rod 31, wherein in the opening and closing guide 32, a support inclined surface 33 having different slopes from an upper end surface is formed so that the opening and closing rod 34 moves downward along the support inclined surface 33 by a self weight.

Preferably, the support inclined surface 33 is formed with a support surface (a) inclined from an upper end surface, a rolling surface (b) having a slope different from that of the support surface (a) while continuing with the support surface (a), and a pressing surface (c) having a slope different from that of the rolling surface (b) while continuing with the rolling surface (b), and when the opening and closing driving cylinder 30 is driven to move the opening and closing rod 34 upward, by moving the opening and closing rod 34 upward while supporting the opening and closing rod 34 through the support surface (a) and the rolling surface (b) of the support inclined surface 33, the opening and closing driving cylinder 30 moves the opening and closing rod 34 to position adjacent to the opening and closing rod receiving portion 24, and as the opening and closing rod 34 receives a pressure within the chamber 10, the opening and closing rod 34 is positioned to close contact with the opening and closing rod receiving portion 24 to seal the chamber 10.

Preferably, the opening and closing means is a cylinder-shaped opening and closing rod 34, and the front opening and closing portion 20 and the rear opening and closing portion 40 include a front housing 21 and a rear housing 41 in which opening and closing rod moving portions 36 and 46 are formed to vertically move the opening and closing rod 34, an opening and closing guide rod 39 connected to an opening and closing rod connector 80 connected to both end portions of the opening and closing rod 34 to support to vertically move the opening and closing rod 34, a plurality of opening and closing guide connecting rods 37 connected orthogonal to the opening and closing guide rod 39 and for penetrating a bottom surface of the front opening and closing portion 20, an opening and closing guide rod moving bar 35 connected to a lower end portion of the plurality of opening and closing guide connecting rods 37, and a plurality of opening and closing driving cylinders 30 mounted at a bottom surface of the front opening and closing portion 20 so as to vertically move the opening and closing guide rod moving bar 35 and to be connected to the opening and closing guide rod moving bar 35.

Preferably, the opening and closing rod connector 80 is a tumbling doll shaped-plate, and a circular central portion of a lower portion is connected to an opening and closing guide rod 39 and an opening and closing guide rod hinge 81, and in a circular central portion of an upper portion, a moving ring portion 84 and a connecting ring portion 85 having different inner diameters are formed in a 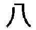 shape, a central portion of the moving ring portion 84 is connected to an opening and closing rod hinge 82 and is fastened to the opening and closing rod connector 80 by a separation prevention plate 83, and the connecting ring portion 85 is formed to have an inner diameter larger than that of the separation prevention plate 83.

Preferably, in the opening and closing guide rod 39, a support inclined surface 33 having different slopes from an upper end surface is formed, wherein the support inclined surface 33 is formed with a support surface (a) inclined from an upper end surface, a rolling surface (b) having a slope different from that of the support surface (a) while continuing with the support surface (a), and a pressing surface (c) having a slope different from that of the rolling surface (b) while continuing with the rolling surface (b), and when the opening and closing driving cylinder 30 is driven to move the opening and closing rod 34 upward, the opening and closing driving cylinder 30 moves the opening and closing rod 34 to position adjacent to the opening and closing rod receiving portion 24 by moving the opening and closing rod 34 upward while supporting the opening and closing rod 34 through the support surface (a) and the rolling surface (b) of the support inclined surface 33, and the opening and closing rod 34 receives a pressure within the chamber 10 and is positioned to close contact with the opening and closing rod receiving portion 24 to seal the chamber 10.

In accordance with an aspect of the present invention, there is an autoclave including: a heating transfer unit 27 for receiving injection of sheet glass bonded by preheat to transfer a product while heating; a chamber 10 including a front opening and closing portion 20 in which a chamber injection port 14 penetrated to a front portion to receive injection of a product from the heating transfer unit 27 and a chamber discharge port 15 penetrated to discharge a product to the rear side are formed and that is mounted in the chamber injection port 14 and in which a product injection port 22 is formed to receive injection of the product, a rear opening and closing portion 40 that is mounted in the chamber discharge port 15 and in which a product discharge port 42 for discharging a product at the inside is formed, and an opening and closing means for opening and closing the product injection port 22 and the product discharge port 42 formed in the front opening and closing portion 20 and the rear opening and closing portion 40, respectively, by an internal pressure; and a cooling air pressing unit 51 for cooling a product while maintaining a pressed state to the chamber 10.

Preferably, the autoclave further includes: a product injection unit 25 for injecting a product to the heating transfer unit 27; and a product discharge unit 45 for discharging a product to the rear side of the chamber 10, wherein the opening and closing means is a cylinder-shaped opening and closing rod 34, and the front opening and closing portion 20 and the rear opening and closing portion 40 includes: a front housing 21 and a rear housing 41 in which opening and closing rod moving portions 36 and 46, respectively, are formed to vertically move the opening and closing rod 34; and an opening and closing driving cylinder 30 mounted at a bottom surface of each of the front housing 21 and the rear housing 41 and for vertically moving the opening and closing rod 34.

Preferably, the autoclave further includes: a product injection unit 25 for injecting a product to the heating transfer unit 27; and a product discharge unit 45 for discharging a product to the rear side of the chamber 10, wherein the opening and closing means is a cylinder-shaped opening and closing rod 34, and the front opening and closing portion 20 and the rear opening and closing portion 40 include: a front housing 21 and a rear housing 41 in which opening and closing rod moving portions 36 and 46, respectively, are formed to vertically move the opening and closing rod 34; an opening and closing guide rod 39 connected to an opening and closing rod connector 80 connected to both end portions of the opening and closing rod 34 to support to vertically move the opening and closing rod 34; a plurality of opening and closing guide connecting rods 37 connected orthogonal to the opening and closing guide rod 39 and for penetrating a bottom surface of the front opening and closing portion 20; an opening and closing guide rod moving bar 35 connected to a lower end portion of the plurality of opening and closing guide connecting rods 37; and a plurality of opening and closing driving cylinders 30 mounted at a bottom surface of the front opening and closing portion 20 so as to vertically move the opening and closing guide rod moving bar 35 to be connected to the opening and closing guide rod moving bar 35.

Preferably, a cooling air pressing unit 51 includes a cooling heat pipe 52 for uniformly and entirely cooling the inside of the chamber 10 by ejecting injected air from an upper surface of the inside of the chamber 10 to a plurality of air nozzles and further includes an air drier 70 for drying air supplied to the cooling heat pipe 52 and an exhaust unit 56 for discharging internal air to the outside by air injected through the cooling air pressing unit 51 while constantly maintaining an internal pressure of the chamber 10.

### Advantageous effects

As described above, according to the present invention, a safety accident such as explosion that may occur when using a sealed chamber can be previously prevented from occurring, and a device can be simply formed, and particularly, a safety accident according to an incomplete back pressure can be structurally prevented from occurring.

Further, because a supply and discharge process of a product formed in a large size can be formed with an in-line, a tact time can be greatly shortened.

In the present invention, while preserving a temperature of glass bonded by a pre-load, by uniformly cooling a product with cooling air, there is a merit that a quality of a product is greatly improved and a product can be produced in a small scale.

Further, the autoclave can be equally or variously independently operated to correspond to a requiring condition of a product to process and can have a more efficient disposal ability, a quality thereof can be very effectively managed and thus the autoclave has a superior effect in which productivity of the product is greatly improved.

### Brief Description of Drawings

FIG. 1 is a cross-sectional view illustrating an opening and closing device of an autoclave in an opened state according to an exemplary embodiment of the present invention.
FIG. 2 is a cross-sectional view illustrating an opening and closing device of an autoclave in a closed state according to an exemplary embodiment of the present invention.
FIGS. 3A and 3B are enlarged cross-sectional views of a major portion explaining an opening and closing operation in an opening and closing device of an autoclave according to an exemplary embodiment of the present invention.
FIGS. 4A to 4C are cross-sectional views illustrating an opening and closing device of an autoclave according to another exemplary embodiment of the present invention.
FIG. 5 illustrates an opening and closing rod connector in an opening and closing device of an autoclave according to another exemplary embodiment of the present invention.
FIG. 6 is a front view of an opening and closing device of an autoclave according to another exemplary embodiment of the present invention.
FIG. 7 is a block diagram of an autoclave in which an opening and closing device of the autoclave is mounted according to another exemplary embodiment of the present invention.
FIG. 8 is a perspective view illustrating an autoclave according to another exemplary embodiment of the present invention.
FIG. 9 is a cross-sectional view illustrating a conventional general chamber.
FIG. 10 is a flowchart illustrating a production process of conventional general bonding safety glass.

### Best modes for carrying out the invention

Hereinafter, an opening and closing device of an autoclave and the autoclave according to an exemplary embodiment of the present invention will be described in detail with reference to the accompanying drawings.

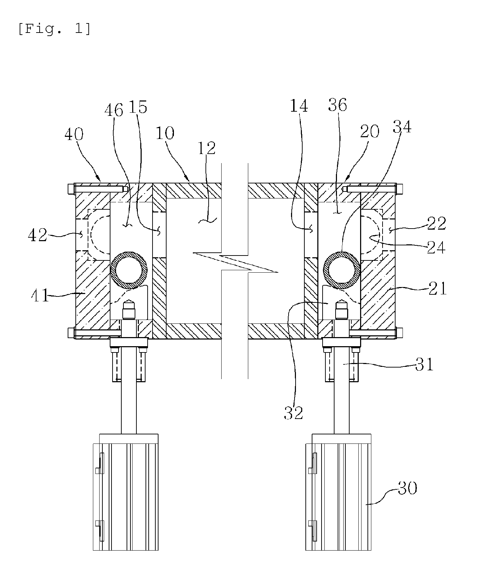

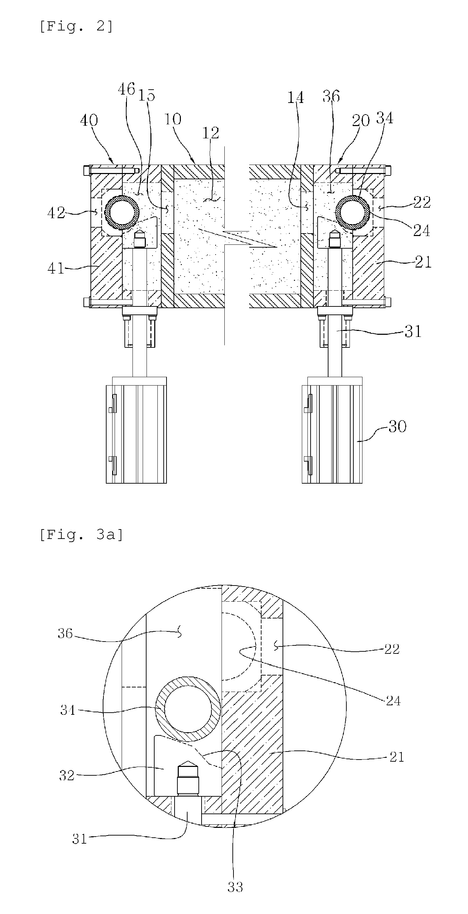

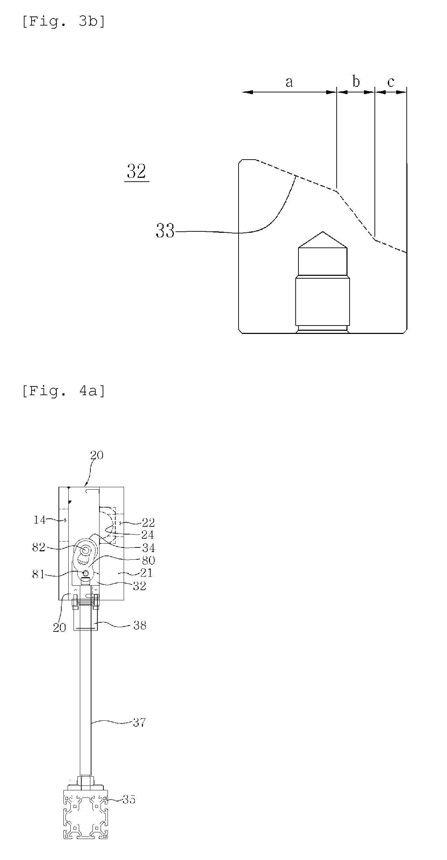

FIG. 1 is a cross-sectional view illustrating an opening and closing device of an autoclave in an opened state according to an exemplary embodiment of the present invention, FIG. 2 is a cross-sectional view illustrating an opening and closing device of an autoclave in a closed state according to an exemplary embodiment of the present invention, and FIGS. 3A and 3B are enlarged cross-sectional views of a major portion explaining an opening and closing operation in an opening and closing device of an autoclave according to an exemplary embodiment of the present invention.

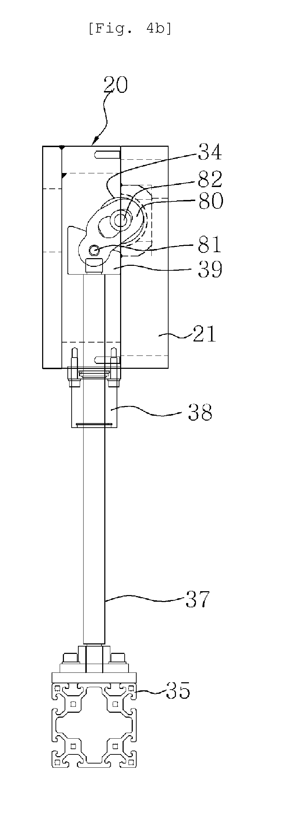

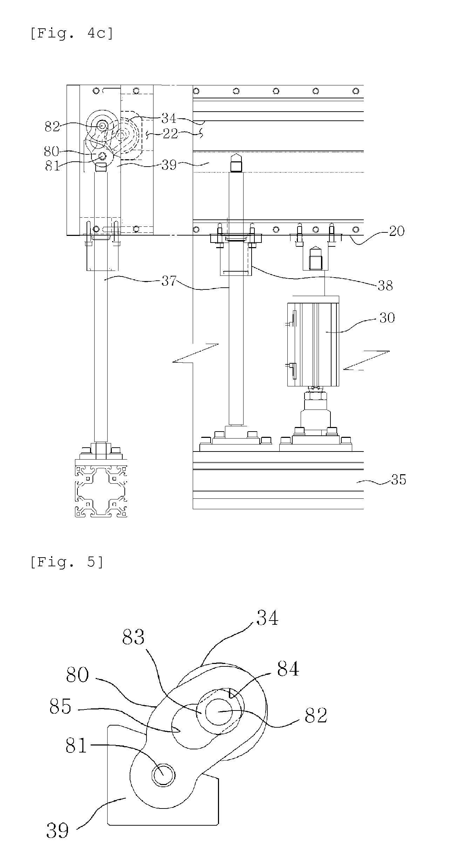

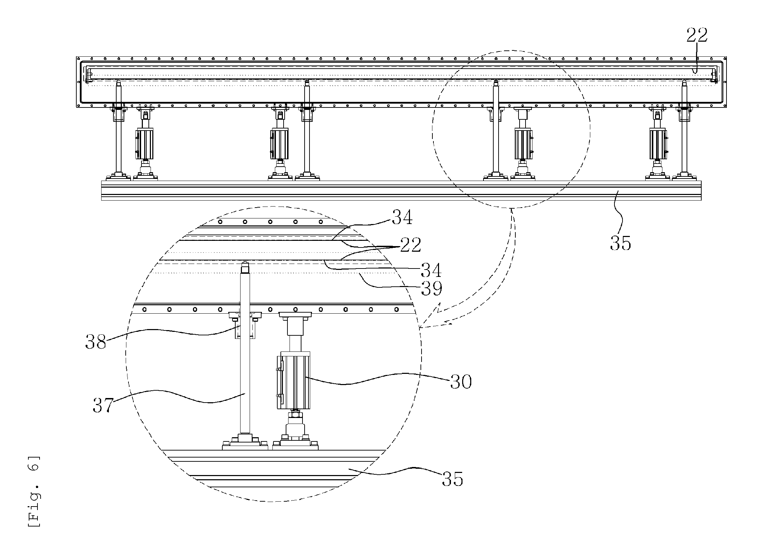

Further, FIGS. 4A to 4C are cross-sectional views illustrating an opening and closing device of an autoclave according to another exemplary embodiment of the present invention, FIG. 5 illustrates an opening and closing rod connector in an opening and closing device of an autoclave according to another exemplary embodiment of the present invention, and FIG. 6 is a front view of an opening and closing device of an autoclave according to another exemplary embodiment of the present invention.

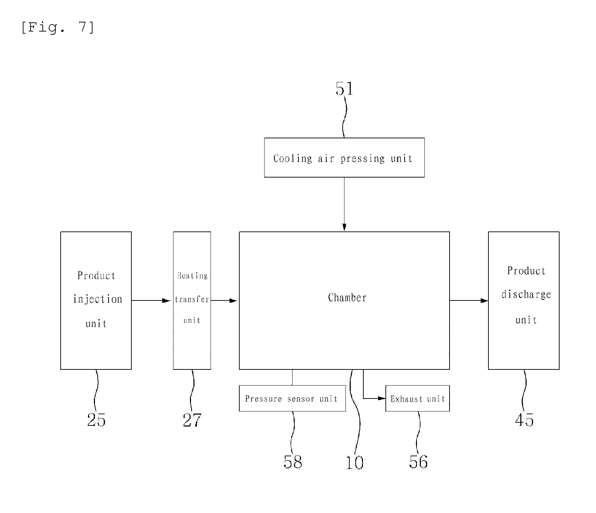

FIG. 7 is a block diagram of an autoclave in which an opening and closing device of the autoclave is mounted according to another exemplary embodiment of the present invention, and FIG. 8 is a perspective view illustrating an autoclave according to another exemplary embodiment of the present invention.

Like reference numerals designate like elements throughout the specification. Further, detailed descriptions of well-known functions and structures incorporated herein may be omitted to avoid obscuring the subject matter of the present invention. Further, a directional term such as an 'upper portion', a 'lower portion', a 'front portion', a 'rear portion', 'the front end', 'the front end', and 'the rear end' is used in relation to orientation of disclosed drawings. Because constituent elements according to an exemplary embodiment of the present invention may be positioned with various orientations, a directional term is used for not limiting but illustrating.

As shown in FIGS. 1, 2, 3A, and 3B, an opening and closing device of an autoclave according to an exemplary embodiment of the present invention includes a quadrangle-shaped chamber 10, a front opening and closing portion 20 mounted at the outside of a front surface portion of the chamber 10, and a rear opening and closing portion 40 mounted to correspond to the front opening and closing portion 20 at the outside of a rear surface portion of the chamber 10.

In the chamber 10, a chamber injection port 14 is formed to receive injection of a product through the front opening and closing portion 20, and a chamber discharge port 15 is formed to discharge a product through the rear opening and closing portion 40.

In the front opening and closing portion 20, a product injection port 22 mounted in the chamber injection port 14 to receive injection of a product is formed, and in the rear opening and closing portion 40, a product discharge port 42 mounted in the discharge port 15 to discharge a product at the inside of the chamber 10 is formed. Further, the front opening and closing portion 20 and the rear opening and closing portion 40 include an opening and closing means for opening and closing the product injection port 22 and the product discharge port 42, respectively, by a pressure within the chamber 10.

In an exemplary embodiment of the present invention, the opening and closing means may use a cylinder-shaped opening and closing rod 34 that receives and moves a pressure within the chamber 10.

The front opening and closing portion 20 includes an opening and closing rod moving portion 36 that can vertically move the opening and closing rod 34, a front housing 21 in which the product injection port 22 is formed, and an opening and closing driving cylinder 30 mounted at a bottom surface and for vertically moving the opening and closing rod 34. Further, similar to the front opening and closing portion 20, the rear opening and closing portion 40 includes a rear housing 41 and the opening and closing driving cylinder 30 in which an opening and closing rod moving portion 46 and the product discharge port 42 are formed to vertically move the opening and closing rod 34.

It is preferable that the product injection port 22 formed in the front housing 21 and the product discharge port 42 formed in the rear housing 41 are formed in a quadrangular shape to inject or exhaust a flat plate display or bonding safety glass and are formed to communicate with the inside 12 of the chamber through the opening and closing rod moving portions 36 and 46, the chamber injection port 14, and the discharge port 15 from the outside, and at an inner side surface of the front housing 21 and the rear housing 41 adjacent to the opening and closing rod moving portions 36 and 46, in order to receive to close contact the opening and closing rod 34, opening and closing rod receiving portions 24 and 44 engraved in a half-circular arc shape are formed.

The opening and closing driving cylinder 30 operate in a pneumatic pressure or a fluid pressure, and a cylinder rod 31 operates to vertically move the opening and closing rod 34. Here, in an upper end portion of the cylinder rod 31, an opening and closing guide 32 is mounted to enable the opening and closing rod 34 to be disposed adjacent to the product injection port 22 and the product discharge port 42 formed in the front housing 21 and the rear housing 41 and thus the opening and closing guide 32 closes the product injection port 22 and the product discharge port 42 by an internal pressure of the chamber 10 or opens the product injection port 22 and the product discharge port 42 by a self weight of the opening and closing rod 34.

As shown in FIG. 3B, in the opening and closing guide 32, it is preferable that a support inclined surface 33 having different slopes from an upper end surface is formed and the opening and closing rod 34 is formed to move downward along the support inclined surface 33 by a self weight. In more detail, it is preferable that the support inclined surface 33 is formed with a support surface (a) having a slow slope from an upper end surface, a rolling surface (b) having a sharp slope, and a pressing surface (c) having a slow slope, and when the opening and closing driving cylinder 30 drives to move the opening and closing rod 34 upward, the opening and closing driving cylinder 30 moves the opening and closing rod 34 upward while supporting the opening and closing rod 34 through the support surface (a) and the rolling surface (b) of the support inclined surface 33 formed in the opening and closing guide 32, and the opening and closing driving cylinder 30 moves the opening and closing rod 34 so that the opening and closing rod 34 is received adjacent to the opening and closing rod receiving portion 24 according to rising driving of the opening and closing driving cylinder 30. Thereafter, as a pressure within the sealed chamber 10 rises, the opening and closing rod 34 is positioned to close contact with the opening and closing rod receiving portion 24 to completely seal the chamber 10. Here, the pressing surface (c) compresses the opening and closing rod 34 so that the opening and closing rod 34 is positioned to further close contact with the opening and closing rod receiving portion 24.

Even in the rear opening and closing portion 40, the foregoing operation of the opening and closing rod 34 is equally performed to completely seal the chamber 10.

As shown in FIGS. 4A to 6, an opening and closing means according to another exemplary embodiment of the present invention may use a cylinder-shaped opening and closing rod 34 for receiving and moving an internal pressure of the chamber 10 and an opening and closing guide rod 39 for moving the opening and closing rod 34.

Here, the front opening and closing portion 20 includes an opening and closing rod moving portion 36 that can vertically move the opening and closing rod 34, a front housing 21 in which the product injection port 22 is formed, an opening and closing guide rod 39 for supporting to vertically move the opening and closing rod 34, a plurality of opening and closing guide connecting rods 37 connected orthogonal to the opening and closing guide rod 39 and for penetrating a bottom surface of the front opening and closing portion 20, an opening and closing guide rod moving bar 35 connected to a lower end portion of the plurality of opening and closing guide connecting rods 37, and a plurality of opening and closing driving cylinders 30 mounted at a bottom surface of the front opening and closing portion 20 so as to vertically move the opening and closing guide rod moving bar 35 and to be connected to the opening and closing guide rod moving bar 35.

Further, as shown in FIG. 5, it is preferable that both ends of the opening and closing guide rod 39 are an opening and closing rod connector 80 and are connected to interlock with the opening and closing rod 34 and an opening and closing guide rod 39, and the opening and closing guide connecting rod 37 is connected to a lower end portion of the front opening and closing portion 20 and a bushing 38.

The opening and closing rod connector 80 is a plate of a tumbling doll shape, and a circular central portion of a lower portion thereof is connected to an opening and closing guide rod 39 and an opening and closing guide rod hinge 81, and in a circular central portion of an upper portion thereof, a moving ring portion 84 and a connecting ring portion 85 having different inner diameters are each formed in a 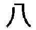 shape. Here, a central portion of the moving ring portion 84 is connected to an opening and closing rod hinge 82 and is fastened to the opening and closing rod connector 80 by a separation prevention plate 83, and the connecting ring portion 85 is formed to have an inner diameter larger than that of the separation prevention plate 83. That is, after inserting the separation prevention plate 83 mounted in the opening and closing rod hinge 82 of the opening and closing rod 34 into the connecting ring portion 85, by moving the opening and closing rod 34 to the moving ring portion 84 and connecting an opening and closing rod connector 80 to an opening and closing guide rod hinge 81 of the opening and closing guide rod 39, assembly is performed.

Therefore, when moving the opening and closing rod 34 upward, the opening and closing rod 34 receives the support of the opening and closing guide rod 39 to move upward and closes the product injection port 22, while the opening and closing guide rod 39 connected to the opening and closing rod connector 80 moves downward, and the opening and closing guide rod 39 pulls the opening and closing rod 34 that closes the product injection port 22, and thus the opening and closing rod 34 smoothly opens the product injection port 22.

Further, similar to the front opening and closing portion 20, in order to vertically move the opening and closing rod 34, the rear opening and closing portion 40 includes an opening and closing guide rod 39, an opening and closing guide connecting rod 37, an opening and closing driving cylinder 30, and an opening and closing guide rod moving bar 35.

Further, at an inner side surface of the front housing 21 and the rear housing 41 adjacent to the opening and closing rod moving portions 36 and 46, opening and closing rod receiving portions 24 and 44 engraved in a half-circle arc shape to receive to close contact the opening and closing rod 34 are formed.

Because a cross-section of the opening and closing guide rod 39 is formed with the support inclined surface 33 having different slopes from an upper end surface, as shown in FIG. 3B, it is preferable that the opening and closing rod 34 is formed to move downward along the support inclined surface 33 by a self weight.

Even in the rear opening and closing portion 40, the foregoing operation of the opening and closing rod 34 is equally performed to completely seal the chamber 10.

In operation of an opening and closing device of an autoclave according to an exemplary embodiment of the present invention having the above-described configuration, as shown in FIG. 1 or 4A, in a state in which an internal pressure of the chamber 10 is removed, the product injection port 22 and the product discharge port 42 each are in an opened state.

In a state in which the product injection port 22 is opened, when a product is injected to the inside 12 of the chamber 10 through the product injection port 22 and the chamber injection port 14, the front opening and closing portion 20 and the rear opening and closing portion 40 are driven to close the product injection port 22 and the product discharge port 42, respectively and receive injection of air to raise a pressure of the inside 12 of the chamber 10.

In the front opening and closing portion 20, the opening and closing driving cylinder 30 operates to close the product injection port 22 and operates to dispose the opening and closing rod 40 adjacent to the opening and closing rod receiving portion 24. That is, in an exemplary embodiment of the present invention, a cylinder rod 31 of the opening and closing driving cylinder 30 drives upward, and the opening and closing guide 32 moves the opening and closing rod 34 upward. Further, in another exemplary embodiment of the present invention, when the opening and closing driving cylinder 30 is driven to move an opening and closing guide rod moving bar 35 upward, an opening and closing guide connecting rod 37 is moved upward to move the opening and closing rod 34 upward.

The opening and closing rod 34 is moved upward by the opening and closing guide 32 or the opening and closing guide rod 39 to approach the opening and closing rod receiving portion 24, and the opening and closing rod 34 receives an internal pressure of the chamber 10 is positioned to close contact with the opening and closing rod receiving portion 24 to close the product injection port 22.

Further, the rear opening and closing portion 40 simultaneously drives with the front opening and closing portion 20, and the product injection port 22 and the product discharge port 42 of the chamber 10 are thus closed and thus the sealed chamber 10 completely seals the inside 12 from the outside.

Thereafter, at the inside 12 of the chamber 10, when a processing of the product is complete, an internal pressure of the chamber 10 is discharged, and by driving the opening and closing driving cylinder 30, the cylinder rod 31 moves downward.

In an exemplary embodiment example of the present invention, as an internal pressure of the chamber 10 is exhausted, the opening and closing rod 34 is separated from an opening and closing rod receiving portion 24 by a self weight to open the product injection port 22 and the product discharge port 42. A product is discharged through the opened product discharge port 42 and thus a process is complete.

Further, in another exemplary embodiment of the present invention, while an opening and closing guide connecting rod 37 moves downward by driving of the opening and closing driving cylinder 30, the opening and closing rod 34 smoothly moves downward by an opening and closing rod connector 80 connected to the opening and closing rod 34.

Here, as described above, because an opening and closing device of an autoclave according to an exemplary embodiment of the present invention is formed in a structure in which the product injection port 22 and product discharge port 42 are not opened before an internal pressure of the chamber 10 is entirely exhausted, the opening and closing device previously prevents a safety accident from occurring according to incomplete exhaust of an internal pressure.

Further, by automatically opening and closing without manually opening and closing a chamber formed in a relatively large volume, a tact time can be greatly lowered.

As shown in FIGS. 7 and 8, an autoclave having the foregoing opening and closing device of an autoclave includes a product injection unit 25 for injecting sheet glass bonded by a pre-load, a heating transfer unit 27 for receiving injection of a product from the product injection unit 25 to transfer the product while heating, a chamber 10 including a cooling air pressing unit 51 for receiving injection of a product from the heating transfer unit 27 to apply a pressure and for cooling a product while maintaining a pressed state, and a rear product discharge unit 45 for discharging a product to the rear side of the chamber 10.

Here, the heating transfer unit 27 constantly maintains a temperature of sheet glass bonded by preheat and is transferred in a predetermined speed by a chain belt 28.

The product injection unit 25 and the product discharge unit 45 may be formed with a conveyer transfer belt, but may be formed with a transfer roller 26.

The cooling air pressing unit 51 may include a cooling heat pipe 52 and a compressor. The cooling air pressing unit 51 may further include an air drier 70 for drying injected air and a receiver tank 50.

It is preferable that the cooling air pressing unit 51 further includes an exhaust unit 56 for discharging internal air to the outside by air injected through the cooling air pressing unit 51 while constantly maintaining a pressure within the chamber 10 and a pressure sensor unit 58.

The cooling air uniformly and entirely cools the inside of the chamber 10 through a plurality of air nozzles formed at a predetermined gap at an upper surface of the inside of the chamber 10.

An autoclave according to an exemplary embodiment of the present invention having the above-described configuration transfers safety bonding glass bonded by a pre-load via cutting, washing, and dry processing similar to a conventional method to the heating transfer unit 27 through the product injection unit 25 and transfers the safety bonding glass to the inside of the chamber 10 through the product injection port 22 of the front opening and closing portion 20 of the chamber 10. In this case, preheat of the safety bonding glass bonded by a pre-load is a maintained or heated through the heating transfer unit 27.

Thereafter, after drying air, having passed through a compressor and a reservoir tank 50 with an air drier 70, when a predetermined time has elapsed under a predetermined pressure condition, in order to cool a product within the chamber 10, air, having passed through the air drier 70 is uniformly and entirely ejected at the ceiling of the chamber 10 through the cooling heat pipe 52.

In this case, the chamber 10 discharges air to the outside through the exhaust unit 56 by injected cooling air while maintaining the same pressure at the inside thereof.

Thereafter, when cooling is complete, by driving the rear opening and closing portion 40 of the rear side of the chamber 10, a product is discharged to the outside.

Therefore, because an autoclave according to the present invention transfers while heating a product bonded by a pre-load through a heating transfer unit, energy loss is minimized, and in a chamber, by pressing and uniformly cooling the product, a quality of the product can be greatly improved. Further, by rapidly receiving injection of the product and discharging the product, a tact time according to an entire process can be greatly reduced, and the autoclave can be appropriate to production of a small quantity. Therefore, an incidental cost according to production of a product can be reduced, and a burden of a stock can be greatly reduced.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. An opening and closing device of an autoclave, comprising:
a front opening and closing portion 20 mounted at the outside of a front surface portion of a quadrangle-shaped chamber 10 in which a chamber injection port 14 is formed to receive injection of a product;
a rear opening and closing portion 40 mounted at the outside of a chamber discharge port 15 formed in a rear surface portion of the chamber 10 to discharge the product; and
an opening and closing means for opening and closing a product injection port 22 and a product discharge port 42 formed in the front opening and closing portion 20 and the rear opening and closing portion 40, respectively by an internal pressure of the chamber 10.

2. The opening and closing device of claim 1, wherein the opening and closing means is a cylinder-shaped opening and closing rod 34, and
the front opening and closing portion 20 and the rear opening and closing portion 40 comprise:
a front housing 21 and a rear housing 41 in which opening and closing rod moving portions 36 and 46, respectively, are formed to vertically move the opening and closing rod 34; and
an opening and closing driving cylinder 30 mounted at a bottom surface and for vertically moving the opening and closing rod 34.

3. The opening and closing device of claim 2, wherein in the product injection port 22 and the product discharge port 42, at an inner side surface thereof adjacent to the opening and closing rod moving portions 36 and 46, an opening and closing rod receiving portion 24 engraved in a half-circular arc shape so as to receive to close contact the opening and closing rod 34 is formed.

4. The opening and closing device of claim 2 or 3, wherein the opening and closing driving cylinder 30 comprises a cylinder rod 31 and an opening and closing guide 32 mounted in an end portion of the cylinder rod 31,
wherein in the opening and closing guide 32, a support inclined surface 33 having different slopes from an upper end surface is formed so that the opening and closing rod 34 moves downward along the support inclined surface 33 by a self weight.

5. The opening and closing device of claim 4, wherein the support inclined surface 33 is formed with a support surface (a) inclined from an upper end surface, a rolling surface (b) having a slope different from that of the support surface (a) while continuing with the support surface (a), and a pressing surface (c) having a slope different from that of the rolling surface (b) while continuing with the rolling surface (b), and when the opening and closing driving cylinder 30 is driven to move the opening and closing rod 34 upward, by moving the opening and closing rod 34 upward while supporting the opening and closing rod 34 through the support surface (a) and the rolling surface (b) of the support inclined surface 33, the opening and closing rod 34 is moved to position adjacent to the opening and closing rod receiving portion 24 and receives a pressure within the chamber 10 to be positioned to close contact with the opening and closing rod receiving portion 24 and to seal the chamber 10.

6. The opening and closing device of claim 1, wherein the opening and closing means is a cylinder-shaped opening and closing rod 34, and the front opening and closing portion 20 and the rear opening and closing portion 40 comprise a front housing 21 and a rear housing 41 in which opening and closing rod moving portions 36 and 46 are formed to vertically move the opening and closing rod 34, an opening and closing guide rod 39 connected to an opening and closing rod connector 80 connected to both end portions of the opening and closing rod 34 to support to vertically move the opening and closing rod 34, a plurality of opening and closing guide connecting rods 37 connected orthogonal to the opening and closing guide rod 39 and for penetrating a bottom surface of the front opening and closing portion 20, an opening and closing guide rod moving bar 35 connected to a lower end portion of the plurality of opening and closing guide connecting rods 37, and a plurality of opening and closing driving cylinders 30 mounted at a bottom surface of the front opening and closing portion 20 so as to vertically move the opening and closing guide rod moving bar 35 and to be connected to the opening and closing guide rod moving bar 35.

7. The opening and closing device of claim 6, wherein the opening and closing rod connector 80 is a tumbling doll shaped-plate, and a circular central portion of a lower portion is connected to an opening and closing guide rod 39 and an opening and closing guide rod hinge 81, and in a circular central portion of an upper portion, a moving ring portion 84 and a connecting ring portion 85 having different inner diameters are formed in a 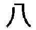 shape, a central portion of the moving ring portion 84 is connected to an opening and closing rod hinge 82 and is fastened to the opening and closing rod connector 80 by the separation prevention plate 83, and the connecting ring portion 85 is formed to have an inner diameter larger than that of the separation prevention plate 83.

8. The opening and closing device of claim 6 or 7, wherein in the opening and closing guide rod 39, a support inclined surface 33 having different slopes from an upper end surface is formed, wherein the support inclined surface 33 is formed with a support surface (a) inclined from an upper end surface, a rolling surface (b) having a slope different from that of the support surface (a) while continuing with the support surface (a), and a pressing surface (c) having a slope different from that of the rolling surface (b) while continuing with the rolling surface (b), and when the opening and closing driving cylinder 30 is driven to move the opening and closing rod 34 upward, the opening and closing driving cylinder 30 moves the opening and closing rod 34 to position adjacent to the opening and closing rod receiving portion 24 by moving the opening and closing rod 34 upward while supporting the opening and closing rod 34 through the support surface (a) and the rolling surface (b) of the support inclined surface 33, and the opening and closing rod 34 receives a pressure within the chamber 10 and is positioned to close contact with the opening and closing rod receiving portion 24 to seal the chamber 10.

9. An autoclave, comprising:
a heating transfer unit 27 for receiving injection of sheet glass bonded by preheat to transfer a product while heating;
a chamber 10 comprising a front opening and closing portion 20 in which a chamber injection port 14 penetrated to a front portion to receive injection of a product from the heating transfer unit 27 and a chamber discharge port 15 penetrated to discharge a product to the rear side are formed and that is mounted in the chamber injection port 14 and in which a product injection port 22 is formed to receive injection of the product, a rear opening and closing portion 40 that is mounted in the discharge port 15 and in which a product discharge port 42 for discharging a product at the inside is formed, and an opening and closing means for opening and closing the product injection port 22 and the product discharge port 42 formed in the front opening and closing portion 20 and the rear opening and closing portion 40, respectively, by an internal pressure and
a cooling air pressing unit 51 for cooling a product while maintaining a state pressed to the chamber 10.

10. The autoclave of claim 9, further comprising:
a product injection unit 25 for injecting a product to the heating transfer unit 27; and
a product discharge unit 45 for discharging a product to the rear side of the chamber 10,
wherein the opening and closing means is a cylinder-shaped opening and closing rod 34, and
the front opening and closing portion 20 and the rear opening and closing portion 40 comprises:
a front housing 21 and a rear housing 41 in which opening and closing rod moving portions 36 and 46, respectively, are formed to vertically move the opening and closing rod 34; and
an opening and closing driving cylinder 30 mounted at a bottom surface of each of the front housing 21 and the rear housing 41 and for vertically moving the opening and closing rod 34.

11. The autoclave of claim 9, further comprising:
a product injection unit 25 for injecting a product to the heating transfer unit 27; and
a product discharge unit 45 for discharging a product to the rear side of the chamber 10,
wherein the opening and closing means is a cylinder-shaped opening and closing rod 34, and
the front opening and closing portion 20 and the rear opening and closing portion 40 comprise:
a front housing 21 and a rear housing 41 in which opening and closing rod moving portions 36 and 46, respectively, are formed to vertically move the opening and closing rod 34;
an opening and closing guide rod 39 connected to an opening and closing rod connector 80 connected to both end portions of the opening and closing rod 34 to support to vertically move the opening and closing rod 34;
a plurality of opening and closing guide connecting rods 37 connected orthogonal to the opening and closing guide rod 39 and for penetrating a bottom surface of the front opening and closing portion 20;
an opening and closing guide rod moving bar 35 connected to a lower end portion of the plurality of opening and closing guide connecting rods 37; and
a plurality of opening and closing driving cylinders 30 mounted at a bottom surface of the front opening and closing portion 20 so as to vertically move the opening and closing guide rod moving bar 35 to be connected to the opening and closing guide rod moving bar 35.

12. The autoclave of claim 10 or 11, wherein the cooling air pressing unit 51 comprises a cooling heat pipe 52 for uniformly and entirely cooling the inside of the chamber 10 by ejecting injected air from an upper surface of the inside of the chamber 10 to a plurality of air nozzles and further comprises an air drier 70 for drying air supplied to the cooling heat pipe 52 and an exhaust unit 56 for discharging internal air to the outside by air injected through the cooling air pressing unit 51 while constantly maintaining an internal pressure of the chamber 10.
